(19) Europäisches Patentamt / European Patent Office / Office européen des brevets

(11) **EP 3 901 701 A1**

(12) **EUROPEAN PATENT APPLICATION**

(43) Date of publication:
**27.10.2021 Bulletin 2021/43**

(51) Int Cl.:
**G03F 7/20** (2006.01)   **G03F 9/00** (2006.01)
**G01N 29/06** (2006.01)   **G01Q 60/32** (2010.01)

(21) Application number: **20171158.7**

(22) Date of filing: **23.04.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Nederlandse Organisatie voor toegepast-natuurwetenschappelijk Onderzoek TNO**
**2595 DA 's-Gravenhage (NL)**

(72) Inventors:
• **HATAKEYAMA, Kodai**
**2595 DA 's-Gravenhage (NL)**
• **QUESSON, Benoit André Jacques**
**2595 DA 's-Gravenhage (NL)**
• **NAVARRO PAREDES, Violeta**
**2595 DA 's-Gravenhage (NL)**
• **MOHTASHAMI, Abbas**
**2595 DA 's-Gravenhage (NL)**
• **VAN NEER, Paul Louis Maria Joseph**
**2595 DA 's-Gravenhage (NL)**
• **PIRAS, Daniele**
**2595 DA 's-Gravenhage (NL)**

(74) Representative: **V.O.**
**P.O. Box 87930**
**2508 DH Den Haag (NL)**

(54) **DETERMINING ALIGNMENT OF LAYERS IN A LAYERED PRODUCT**

(57)   A layered product (10) is provided with at least a lower product layer (120) comprising a first marker configuration (122) with at least a first marker (122a, 122b) and at least a higher product layer (130) that overlays the lower product layer, the at least a higher product layer comprising a second marker configuration (132) with at least a second marker (132a, 132b, 132c).

The first marker configuration (122) and the second marker configuration (132) have mutually different physical properties.

FIG. 1A

## Description

### BACKGROUND OF THE INVENTION

#### Field of the invention

The present invention relates to a layered product.

The present invention further relates to a method of determining an alignment and/or overlay accuracy of layers in a layered product.

The present invention still further relates to system comprising a layered product and a scanning probe microscopy device.

#### Background

Developments in the semiconductor industry are typically governed by Moore's law which predicts that the number of transistors in a dense integrated circuit doubles every two years. As will be appreciated, this poses significant technological challenges whenever technological boundaries constituted by physical laws are encountered and need to be overcome to meet the industry demands for even smaller and smaller integrated circuits.

One typical challenge encountered already in the twentieth century, was the need to take into account interlayer misalignment between functional layers of a multilayer semiconductor device. In the multilayered structure of semiconductor devices, functional device layers are typically deposited on top of other functional device layers. The functional product features, i.e. the features of the pattern formed in each layer, need to be aligned accurately with those in contiguous functional layers to enable correct operation of the end product: the semiconductor device. This is achieved by monitoring an overlay error during manufacturing, i.e. the amount of misalignment between subsequent layers, by determining relative positions between marker elements in subsequent layers. This improvement, and the advancements achieved after this in the determination of overlay errors, has allowed to continue making semiconductor elements smaller and smaller over the past decades, in accordance with Moore's law.

The current state of the technology that is applied for measuring overlay error, is the use of diffraction optics to determine a relative distance between marker elements. A disadvantage of these methods is that they cannot be applied to methods such as extreme ultraviolet (EUV) lithography, as EUV resists are based on metals which are opaque to light in that wavelength range.

Another disadvantage of the current determination methods for determining overlay error, is that the marker features that can be 'seen' using the diffraction optical methods applied are of much larger dimensions than the functional product features, i.e. pattern features, that are nowadays desired in accordance with Moore's law. Therefore, even if the correct alignment of marker elements in subsequent layers of a multilayer semiconductor device can be established by monitoring the overlay error with existing techniques, it can still not be guaranteed that also the smaller pattern features in subsequent layers are correctly aligned. These small pattern features are affected differently by sensing errors, e.g. lens errors, of the alignment sensor used for determining the overlay error. Hence, an undesired or destructive overlay error is more and more difficult to rule out during manufacturing.

It has been shown that subsurface AFM can be a solution to overcome these problems. Subsurface imaging combines atomic force microscopy (AFM) and ultrasound excitation to extract information of the subsurface features in a sample, such as a (semi-finished) semiconductor product. This is done by measuring the local elasticity variations in the sample, instead of the optical properties that is used in conventional techniques.

In elasticity-based scanning surface probe microscopy (SSPM,) the sample or the cantilever are actuated at ultrasound frequencies near or above the contact resonance of the cantilever (excitation frequency < 1GHz). Therewith, the tip indentation generates a stress field under the sample surface. The stress field is modified by stiffness variations, for example due to subsurface features having a stiffness different from that of the surrounding media (host/main/background material). The stress field variations result in corresponding variations in the cantilever's resonance frequency. In some embodiments the cantilever is allowed to resonate at its resonance frequency and as a consequence, the measured frequency is indicative for the stress field. In other embodiments, the cantilever frequency is fixed, and as a consequence,, the resonance shift of the cantilever results in variations in amplitude and phase of the probe dynamic motion. Hence, a sense signal indicative for variations in the cantilever's resonance frequency or in the amplitude and phase is indicative for the location of subsurface features. Although it is possible in this way to determine how mutually different product layers are aligned, this becomes more and more complicated with an increasing number of layers in the sample, because each layer contributes to the sense signal and it becomes more and more difficult to distinguish the contributions of each layer.

### SUMMARY OF THE INVENTION

It is an first object of the invention to provide an improved layered product that better facilitates determining an alignment of its product layers.

It is a second object of the invention to provide a method of determining an alignment of product layers in the improved product..

It is a third object of the invention to provide a system comprising the improved product and a scanning probe microscopy device.

In accordance with the first object a layered product is provided with at least a lower product layer comprising a first marker configuration with at least a first marker and at least a higher product layer that overlays the lower product layer and that comprises a second marker configuration with at least a second marker. The improved layered product is characterized in that the first marker configuration and the second marker configuration have mutually different physical properties. It is noted that an elements serving as a marker in a marker configuration of a layer may exclusively serve that purpose, but may additionally function as an electronic component in the layer.

Due to the fact that the marker configuration of mutually different product layers have mutually different physical properties, it can be more easily determined with subsurface AFM which signal components originate from which of the product layers. This is highly relevant in view of the fact that current semiconductor products may have a significant number of product layers. By way of example 3D NAND devices are produced with for example from 50 to 200 layers, and the stack of layers may have a thickness of a few micron. Other examples of layer products may optical devices with a plurality of layers such as photonic integrated circuits, or hybrid integrated circuits comprising optical functional layers and electronic functional layers, and/or hybrid functional layers, comprising both optical elements, electronic elements or electro-optic elements, e. g. to convert electric signals into optical signals, to convert optical signals into electric signals or to allow an interaction between one or more electric signals and one or more optical signals. It is noted that the wording "layered product" both refers to an end-product and a semi-finished product. A manufacturing system may for example include inspection stations wherein an alignment of layers in a semi-finished product is determined before is proceeds to the next stage in the manufacturing process. This information can be used to provide alignment control signals to a preceding manufacturing stage to avoid that an alignment deviation tends to drift away to above a threshold value, and/or to reject the semi-finished product in case the alignment deviation has exceeded the threshold value. Likewise such an inspection station may be provided after the last stage to determine the alignment of layers in the end product and to provide alignment control signals to preceding manufacturing stages to avoid that an alignment deviation tends to drift away to above a threshold value, and/or to reject the end product in case the alignment deviation has exceeded the threshold value.

In some embodiments of the layered product the first marker configuration and the second marker configuration have mutually different physical properties in that a lateral dimension of the at least a first marker in the first marker configuration differs from that of the at least a second marker in the second marker configuration. In particular it is favorable if markers in lower arranged product layers have a lateral dimension that is relatively large as compared to higher arranged product layers. Therewith a reduction in resolution with which features in lower arranged layers can be identified is compensated.

In some embodiments the first marker configuration and the second marker configuration have mutually different physical properties in that the at least a first marker in the first marker configuration has a depth profile different from the depth profile of the at least a second marker in the second marker configuration.

In some embodiments the first marker configuration and the second marker configuration have mutually different physical properties in that at least one marker in one of the first marker configuration and the second marker configuration is of a material having a stiffness different from that of at least one other marker of the first marker configuration and the second marker configuration. In this connection, Si and SiN are examples of materials having a mutually different stiffness.

In some embodiments the at least a first marker in the first marker configuration is one of a plurality of first markers and the at least a second marker in the second marker configuration is one of a plurality of second markers. Various additional options are available to provide mutually distinguishable first and second marker configurations in this way. According to one of these options the first pattern differs from the second pattern by having mutually different values for one or more of a spatial frequency, a duty cycle and a phase with which the plurality of markers is arranged therein. According to another one of these options at least one layer comprises a marker configuration with an encoded pattern of markers that is specific for said at least one layer. The code expressed by the marker pattern may be a direct representation of a binary number that identifies the layer, but may also be provided in a more robust manner, for example by using an error correction code with additional code bits. In particular, a very robust encoding can be obtained if the encoded pattern of markers is provided as a two-dimensional pattern in the at least one layer.

It is noted that various approaches may be combined to provide mutually different marker configurations with mutually different physical properties.

In accordance with the second object, claim 10 provides an improved method of determining an alignment/overlay accuracy of the at least a lower product layer and the at least a higher product layer in an improved layered product as specified above. The improved method uses a scanning probe microscopy device that comprises at least one scan head including a probe, with a flexible carrier and a probe tip arranged on the flexible carrier,

The improved method comprises:

moving the probe tip and the layered product relative to each other in one or more directions parallel to the surface of the layered product for scanning said surface with the probe tip; and
monitoring motion of the probe tip relative to the scan head with a tip state detector during said scanning for obtaining a sense signal.

The improved method further comprises:

during said scanning, applying at least a first acoustic input signal comprising a signal component at a first frequency to at least one of the probe or the layered product;
analyzing the sense signal for determining an alignment and/or overlay error of the at least a first marker configuration in the lower product layer and the at least a second marker configuration in the higher product layer.

In accordance with the third object, claim 16 provides an improved system that comprises an improved layered product as specified above as well as a scanning probe microscopy device to determine an alignment and/or overlay accuracy of the at least a lower product layer and the at least a higher product layer in the improved layered product.

The scanning probe microscopy device in the improved system comprises at least one scan head, a scan unit, an acoustic signal generator, a tip state detector, a signal detector and a signal analyzer. The scan head includes a probe comprising a flexible carrier and a probe tip arranged on the flexible carrier.

The scanning probe microscopy device in the improved system is configured to assume an operational mode.

In the operational mode, the scan unit is configured to move the probe tip and the layered product relative to each other in one or more directions parallel to a surface of the layered product for scanning said surface with the probe tip. The probe tip is usually moved by scanning the head. In practice, the probe tip can also be moved vertically for example to adapt to the surface level or to control an indentation.

In the operational mode, the acoustic signal generator is configured to apply at least a first acoustic input signal comprising a signal component at a first frequency to at least one of the probe or the layered product during operation of the scan unit.

In the operational mode the tip state detector is configured to monitor motion of the probe tip relative to the scan head for obtaining a sense signal.

In the operational mode, the signal detector is configured to detect a sub-surface detection signal based on the sense signal; and

In the operational mode, the signal analyzer is configured to analyze the sub-surface detection signal for determining an alignment and/or overlay error of the at least a first marker configuration in the lower layer and the at least a second marker configuration in the higher layer.

In order to improve accuracy, measurements may be repeated, and detected signal values and/or analysis results may be averaged. In that case monitoring is performed multiple times and an average value is computed for the sense signal values obtained therewith

In an embodiment of the method the scanning is performed for the lower product layer with an indentation of the probe tip into the product surface that is larger than that when performing the scanning of the higher product layer. With a larger indentation the stress field extends deeper so that the output signal is more dominated by the at least a first marker configuration in the lower layer than in case of a smaller indentation. By performing scanning with mutually different indentations, the pattern information from the at least a first marker configuration and from the at least a second marker configuration can be more easily extracted from the output signals. According to a first approach the larger indentation of the probe tip is achieved by a larger static force exerted on the probe tip. According to a second approach the larger indentation of the probe tip is achieved by using a modulated actuation with a higher carrier frequency. Also these approaches may be combined to control the indentation.

In an example of this embodiment, monitoring is performed subsequently with a first, relatively large indentation set for the lower product layer and with a second, relatively small indentation set for the higher product layer. Therewith a first sense signal is obtained from the measurement with the first, relatively large indentation that is dominated by the pattern information from the lower product layer and a second sense signal is obtained from the measurement with the relatively small indentation that is dominated by the pattern information from the higher product layer. As the first marker configuration and the second marker configuration have mutually different physical properties, a first set of pattern information for the lower product layer and for the higher product layer can be extracted from the first sense signal. Similarly, a second set of pattern information for the lower product layer and for the higher product layer can be extracted from the second sense signal. Also in this embodiment, an average value can be obtained from the pattern information of the lower product layer extracted from the first sense signal and the pattern information of the lower product layer extracted from the second sense signal. Similarly, an average value can be obtained from the pattern information of the higher product layer extracted from the first sense signal and the pattern information of the higher product layer extracted from the second sense signal. Therewith the results may be weighted to take into account the accuracies of the individual measurements. E.g. in general, the pattern information from the lower product layer obtained with the first, relatively large indentation setting will be more accurate than that obtained with the second, relatively small indentation setting and therewith should be assigned a larger weight. Conversely, the pattern information from the higher product layer obtained with the second, relatively small indentation setting will be more accurate than that obtained with the first, relatively large indentation setting as the measurement signal is less affected by lower arranged product layers. Accordingly, in this case, a more accurate result is expected if the pattern information from the higher product layer obtained with the second, relatively small indentation setting is given a larger weight.

In typical products a large number of product layers may be present. In that case the measurements may be performed for various indentation settings. For any product layer an average value can be computed from the pattern information extracted from each of the indentation settings. It is not necessary that a respective indentation setting is selected for each of the product layers. For example when 100 layers are present a measurement may be performed for 10 indentation settings. In some cases a high throughput may be more important. In these cases, the measurement may be performed with a single indentation setting, which is usually an indentation setting that would normally be used for the lowest one of the product layers. With this setting, the stress field properly reaches all product layers, including the lowest one. As the marker configurations of the various product layers have mutually different physical properties, also in that case respective pattern information for each of the product layers can be extracted from the sense signal obtained with the measurements.

BRIEF DESCRIPTION OF THE DRAWINGS

These and other aspects are described in more detail with reference to the drawing. Therein:

FIG. 1 schematically shows an embodiment of a system that comprises a layered product and a scanning probe microscopy device.
FIG. 1A shows in more detail an example of a semi-finished layered product in said embodiment.
FIG. 1B, schematically shows an example of a part of the scanning probe microscopy device in said embodiment.
FIG. 1C illustrates an operation of the system of FIG. 1.
FIG. 2 shows an alternative embodiment of a layered product
FIG. 3 shows a still further alternative embodiment of a layered product.
FIG. 4 shows a product layer in again other embodiment of the layered product.
FIG. 5 shows a still further embodiment of a layered product. Therein the upper part of FIG. 5 shows a cross-section through three product layers. The lower part of FIG. 5 shows a cross-section through one of the product layers according to $Z_{120}$-$Z_{120}$ in the upper part of FIG. 5.
FIG. 6 shows another embodiment of a system comprising a layered product and a scanning probe microscopy device.
FIG. 7 schematically shows a part of an embodiment of the scanning probe microscopy device.

DETAILED DESCRIPTION OF EMBODIMENTS

Like reference symbols in the various drawings indicate like elements unless otherwise indicated.

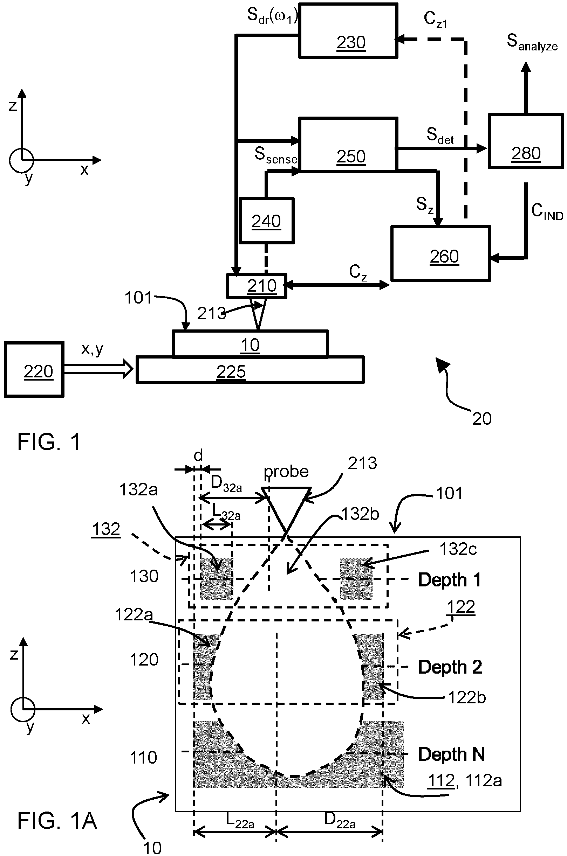

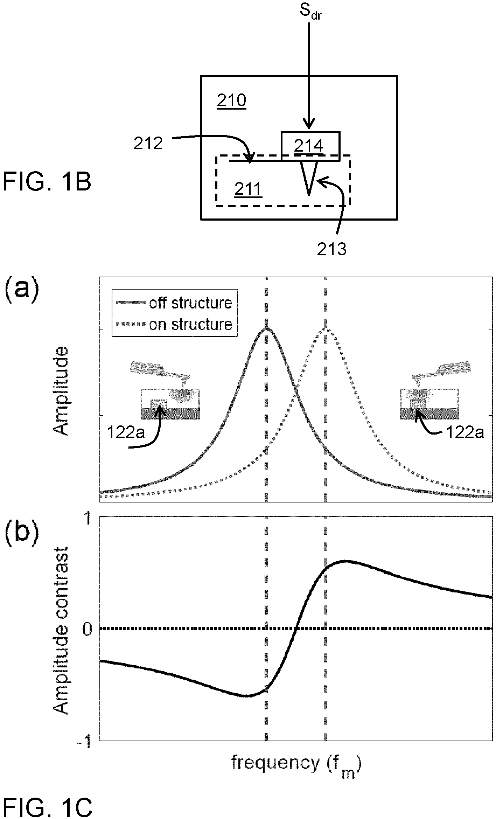

FIG. 1 schematically shows a system that comprises a layered product 10, and a scanning probe microscopy device 20. The layered product 10 may be a semi-finished product, but may alternatively be an end-product. An embodiment of a semi-finished layered product 10 is show in FIG. 1A.. The layered product 10 has a product surface 101 and at least a lower product layer 120 and at least a higher product layer 130 that overlays the lower product layer. As shown in FIG. 1A further product layers may be present, such as a base layer 110. Alternatively or additionally one or more product layers may be present between the product layers 120, 130. Also it is conceivable that product layers are present above product layer 130, for example when inspecting an end product.

The lower product layer 120 comprises a first marker configuration 122 with at least a first marker 122a. The higher product layer 130 comprises a second marker configuration 132 with at least a second marker 132a. The first marker configuration 122 and the second marker configuration 132 have mutually different physical properties.

In the example shown in FIG. 1A, this is the case in that a lateral dimension $L_{22a}$ of the at least a first marker 122a in the first marker configuration 122 is larger than the lateral dimension $L_{32a}$ of the at least a second marker 132a in the second marker configuration 132.

In the embodiment shown in FIG. 1A the layered product 10 it is further the case, that the at least a first marker 122a in the first marker configuration 122 is one of a plurality 122a, 122b of first markers arranged in a first pattern. Also the at least a second marker 132a in the second marker configuration 132 is one of a plurality 132a, 132b, 132c of second markers, but in a second pattern, different from the first pattern.

In the embodiment shown in FIG. 1A, the first pattern differs from the second pattern in that the plurality 132a, 132b, 132c of second markers in the second marker configuration 132 is arranged with a spatial frequency $f_{32}$ that differs from a spatial frequency $f_{22}$ with which the plurality 122a, 122b, 122c of first markers is arranged in the first marker configuration 122. I.e. the second markers in the second marker configuration 132 are arranged periodically with a spatial period $D_{32a}$. Therewith the spatial frequency of the second markers in the second marker configuration 132 is $1/D_{32a}$. The first markers in the first marker configuration 122 are arranged periodically with a longer spatial period $D_{22a}$. Therewith the spatial frequency of the second markers in the second marker configuration 122 is $1/D_{22a}$ which spatial frequency is lower than that in the second marker configuration 132.

In the embodiment shown in FIG. 1A, the first pattern further differs from the second pattern in that the plurality 132a, 132b, 132c of second markers in the second marker configuration 132 is arranged with duty cycle different from the duty cycle which the plurality 122a, 122b, 122c of first markers is arranged in the first marker configuration122. The duty cycle $\delta_{32a}$ of the second markers in the second marker configuration 132 is defined by the ratio:

$$\delta_{32a} = L_{32a}/D_{32a}$$

The duty cycle $\delta_{22a}$ of the first markers in the first marker configuration 122 is defined by the ratio:

$$\delta_{22a} = L_{22a}/D_{22a}$$

It can be seen that $\delta_{32a} < \delta_{22a}$.

It is not necessary that the first marker configuration 122 and the second marker configuration 132 differ in each of these respects. It may for example be the case that the marker configurations each include only a single marker, wherein the lateral dimension of the single marker in the lower layer 120 is larger than the lateral dimension of the single marker in the higher layer 130. Alternatively it may be the case that the markers in the first marker configuration 122 have the same lateral dimension as the marker in the second marker configuration 132, but that the spatial frequency with which the markers are arranged in first marker configuration 122 differs from the spatial frequency with which the markers are arranged in second marker configuration 132. If the markers are arranged in a direction corresponding to the direction in which the lateral dimension is defined, this also implies that the duty cycle is different. In that case, a larger spatial frequency implies a shorter duty cycle. However, the duty cycle can remain constant if the markers are arranged in a lateral direction different from the direction in which the lateral dimension is defined and if the further lateral dimension of the markers in that different lateral direction is adapted. In FIG. 1A this can be the case that the markers have the same lateral dimension in the direction y, but that the further lateral dimension in the direction x is smaller for the markers that are arranged with a higher spatial frequency in that direction x.

In the embodiment of FIG. 1A, it is also the case that the first pattern differs from the second pattern in that a phase with which the plurality 132a, 132b, 132c of second markers is arranged in the second marker configuration 132 differs from a phase with which the plurality 122a, 122b, 122c of first markers is arranged in the first marker configuration 122. This can be seen in that the boundary of the first marker configuration 122 is shifted with a distance d with respect to the boundary of the second marker configuration 132. Accordingly, also an embodiment is conceivable wherein the markers of the first marker configuration 122 have the same lateral dimensions as the markers of the second marker configuration 132 and that moreover, the markers of the first marker configuration 122 and the markers of the second marker configuration 132 are arranged with the same frequency and duty cycle, but that the first and the second pattern differs by the phase of the arrangement of markers.

Turning back now to FIG. 1, an embodiment of the scanning probe microscopy device 20 to determine an alignment of product layers in the semiconductor 10 is described now in more detail.

As shown in FIG. 1, the scanning probe microscopy device 20 comprises at least one scan head 210, a scan unit 220, an acoustic signal generator 214 (See FIG. 1B), a tip state detector 240, a signal detector 250 and a signal analyzer 280. FIG. 1B, schematically shows an embodiment of the scan head 210. As shown therein, the scan head 210 includes a probe 211 comprising a flexible carrier 212, such as a cantilever or a membrane and a probe tip 213 arranged on the flexible carrier 212.

The scanning probe microscopy device 20 is configured to assume an operational mode wherein it determines an alignment of product layers, for example an alignment between lower product layer 120 and higher product layer 130 in the layered product 10 as follows.

In the operational mode the scan unit 220 is configured to move the probe tip 213 and the layered product 10 relative to each other in one or more directions parallel to a surface 101 so as to scan the surface 101 of the layered product 10 with the probe tip 213. In the example shown, this is achieved in that the scan unit 220 controls an xy-table, forming a carrier 225 for the layered product 10, is moved in x and y directions. For example the scan unit 220 may cause the carrier 225 to perform meandering movement, wherein the layered product is moved along a line in the x-direction, displaced a step in the y-direction, moved back along a line in the x-direction at the new y position, make a further step in y-direction etc. In an alternative embodiment, the scan unit 220 may be configured to cause the layered product 10 to move in a single direction, e.g. the x-direction only. In another arrangement the carrier is held at a fixed position and the scan unit causes the scan head to perform the scanning movement. In a still further arrangement the scan unit comprises a first component that moves the carrier in a first direction and a second component that moves the scan head in a second direction transverse to the first direction.

The acoustic signal generator 214 is configured to apply at least a first acoustic input signal comprising a signal component at a first frequency to at least one of the probe or the layered product during operation of the scan unit. In this embodiment the acoustic signal generator 214 is an actuator responsive to a drive signal Sdr from a driver 230. In the embodiment shown, the actuator is for example a piezo-electric actuator that is acoustically coupled to the probe tip 213. In an alternative embodiment, the acoustic signal may be provided by a modulated laser beam that is directed to the probe tip 213 or to the surface of the layered product 10. Alternatively or in addition, an actuator to deliver an acoustic signal may be provided in the carrier 225.

The tip state detector 240 is configured to monitor motion of the probe tip 213 relative to the scan head for obtaining an sense signal $S_{sense}$. The tip-position detector 240 may for example detect a deflection of an optical beam at the probe tip. Alternatively a piezo -electric sensor may be provided to monitor motion.

The monitored motion is indicative for the presence of sub-surface structures, in particular for the presences of markers, e.g. a marker 122a in a product layer of the layered product. The indentation of the probe tip 213 generates a stress field under the product surface 101. If the marker has a different stiffness as compared to the surrounding media (host/main/background material), the stress field is modified. This modification causes variations in the resonance frequency of the flexible carrier 212 (e.g. a cantilever) of the probe, as schematically illustrated in part (a) of FIG. 1C. In case the frequency of the acoustic signal is maintained constant the resonance shift of the cantilever leads to the variations in amplitude and phase of the probe dynamic motion as shown in part (b) of FIG. 1C. Hence, the amplitude and phase variations are indicative for the location of the markers.

The signal detector 250 is configured to detect a sub-surface detection signal $S_{det}$ based on the sense signal $S_{sense}$. Various approaches are possible. In some embodiments the detection signal $S_{det}$ is obtained by applying a band-pass filter to the sense signal $S_{sense}$. In other embodiments the drive signal $S_{drive}$ is provided as a composite signal having a first and a second signal component with a mutually different frequency and the signal detector 250 detects a difference signal in a frequency band having a central frequency corresponding to the frequency difference between the first and the second signal component. In the embodiment shown, the signal detector 250 extracts the detection signal by downmixing the sense signal $S_{sense}$ with the drive signal $S_{dr}$.

The signal analyzer 280 analyzes the detection signal $S_{sense}$ to generate an output signal $S_{analyze}$ that is indicative for an alignment and/or overlay error of the at least a second marker configuration 132 in the higher product layer 130 with respect to the at least a first marker configuration 122 in the lower product layer 120. Therewith it can be determined whether or not these product layers are properly overlaid and/or aligned with reference to a processing device such as a deposition device or a patterning device .

In the embodiment shown in FIG. 1, the scanning probe microscopy device 20 further comprises an indentation controller 260 that controls an indentation of the probe tip 213 into the layered product 10 with a control signal Cz based on a low-pass input from the signal detector 250. In an embodiment, the scanning probe microscopy device 20 the indentation controller 260 controls the indentation of the probe tip 213 into the product surface such that scanning is performed for the lower product layer 120 with an indentation into the product surface that is larger than that when performing the scanning of the higher product layer 130. With a larger indentation the stress field extends deeper so that the output signal is more dominated by the at least a first marker configuration 122 in the lower layer 120 than in case of a smaller indentation. By performing scanning with mutually different indentations, the pattern information from the at least a first marker configuration 122 and from the at least a second marker configuration 132 can be more easily extracted from the output signals. The indentation with which the indentation controller 260 controls the indentation of the probe tip 213 may be set by an external control signal CIND.

In an embodiment the indentation controller 260 causes a larger indentation of the probe tip 213 by allowing a larger static force to be exerted on the probe tip 213. To that end the scan head 210 may comprise a vertical actuator (not shown) that is controlled by a signal Cz to exert the larger static force. Alternatively, or in addition the larger indentation of the probe tip 213 can be achieved by using a modulated actuation with a higher carrier frequency. When increasing the carrier frequencies substantially above contact resonance frequency, the flexible carrier 212, e.g.a cantilever experiences dynamic stiffening and hence indents further into the product surface. To that end, the indentation controller 260 may control the driver 230 with a control signal $C_{z1}$.

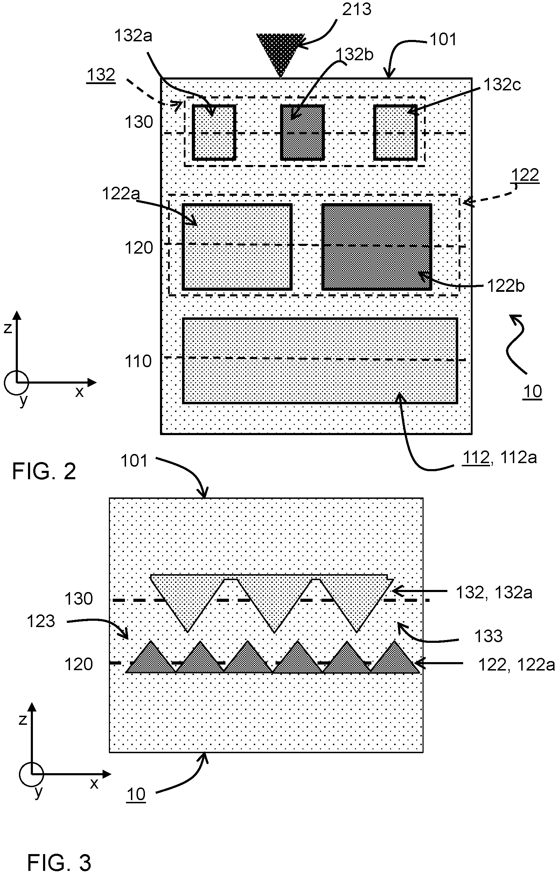

FIG. 2 shows an alternative embodiment of a layered product 10. Parts therein corresponding to FIG. 1A have the same reference number. The layered product 10 as shown in FIG. 2 has at least one marker in one of the first marker configuration 122 and the second marker configuration 132 that is of a material different from that of at least one other marker of the first marker configuration 122 and the second marker configuration 132. In the example shown in FIG. 2, the markers 122a, 132a and 132c (as well as the marker 112a) are of Si and the markers 122b and 132b are of SiN which has a stiffnesss different from that of Si. Therewith a more characteristic sense signal Ssense is obtained that facilitates determining an alignment of the lower product layer 120 and the higher product layer 130.

FIG. 3 shows a still further alternative embodiment of a layered product 10. Parts therein corresponding to FIG. 1A have the same reference number. For illustration purposes only two product layers 120, 130 are shown. However, in practice, this applies also to the examples shown in FIG. 1A and FIG. 2, a substantially larger plurality of product layers, e.g. hundreds of product layers may be present. The layered product 10 shown in this example has a first marker configuration 122 with single marker 122a in the lower product layer 120 and has a second marker configuration 132 with a single marker 132a in the higher product layer 130. The markers 122a, 132a of the first marker configuration 122 and the second marker configuration 132 have mutually different physical properties in that they have a different depth profile. As shown in FIG. 3, the marker 122a is provided with a relief 123 at its upper side and the marker 132a is provided with a relief 133 at its lower side that differs from the relief 123. This facilitates distinguishing marker information from the first marker configuration 122 and the second marker configuration 132 in the sense signal $S_{sense}$. It is noted that in FIG. 3, the markers 122a and 132a are indicated with a different filling in order to more clearly show them in the drawing. It does not necessary imply that the markers 122a and 132a are of mutually different materials. However, to further facilitate distinguishing the marker information from the markers 122a, 132a in the sense signal $S_{sense}$. they may indeed be of a different material, e.g. of Si and SiN respectively, which have a mutually different stiffness.

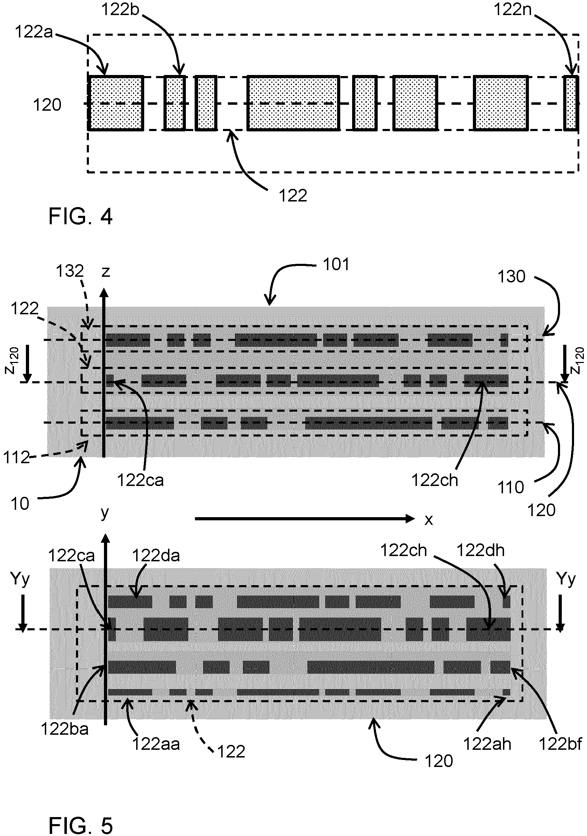

FIG. 4 shows a product layer 120 in again other embodiment of the layered product 10. The product layer 120 has a marker configuration 122 that comprises an encoded pattern of markers 122a, 122b,...,122n that is specific for that marker configuration 122. In a layered product 10 having 100 product layers, the encoded pattern may for example represent a 7-digit binary number indicative for the rank of the layer, wherein the first layer is indicated by the binary number 000000 and the last layer is indicated by the binary number 1100011. Each digit of the binary number has a fixed location. So the first layer can be recognized as a single marker on the fixed location assigned to the least significant digit. The last layer can be recognized as a marker of double length extending over the location assigned to the two most significant digits, an empty space extending over the locations assigned to third and fourth most significant digits a marker of single length extending over the location assigned to the fifth most significant digits and an empty space extending over the locations assigned to the two least significant digits. In practice the marker code may be extended with additional information, for example one reference marker at a same reference location for each of the layers. Instead of simply providing the marker code as the binary number indicative for the rank, the pattern of markers 122a, 122b,..., 122n may be provided as an error correction encodednumber. Such code requires additional code bits. However in practice ample space is available to provide a suitable marker configuration. Identifying the labels with a pattern of markers 122a, 122b,...,122n that represents an error correction encodednumber renders it possible to identify errors if any in the signal $S_{sense}$ and even to correct such errors. One example an error-correction code is the Reed-Solomon code. By adding t check symbols to the data, a Reed-Solomon code can detect (but not correct) any combination of up to and including t erroneous symbols.

Alternatively it is possible to correct up to and including ⌊t/2⌋ erroneous symbols at arbitrary locations. When encoding information in a pattern of markers it can further be particularly taken into account how the pattern of markers is converted to the sense signal to be analyzed. For example a minimum and maximum requirements $L_{min}$, $L_{max}$ may be set for the length of a marker and likewise minimum and maximum requirement $D_{min}$, $D_{max}$ may be set for the distance between subsequent markers.

FIG. 5 shows a still further embodiment of a layered product 10. Therein the upper part of FIG. 5 shows a cross-section through product layers 110, 120, 130. The lower part of FIG. 5 shows a cross-section through the product layer 120 according to $Z_{120}$-$Z_{120}$ in the upper part of FIG. 5. It is further noted that the cross-section in the upper part of FIG. 5 is indicated as Yy-Yy in the lower part of FIG. 5. In this embodiment, an encoded pattern of markers is provided as a two-dimensional pattern in the at least one layer 120. In the lower part of FIG. 5, it can be seen that the marker configuration 122 in layer 120 comprises a first sequence of markers 122aa,...,122ah, a second sequence of markers 122ba,..,122bf, a third sequence of markers 122ca,...,122ch, and a fourth sequence of markers 122da,...,122dh. The vertical cross-section of the third sequence of markers 122ca,...,122ch is visible in the upper half of FIG. 5. It can be seen in the lower half of FIG. 5 that markers in a same sequence of markers have mutually the same width which is specific for each sequence. The specific width may differ among marker sequences. Alternatively, also markers within a same sequence may differ in width.

In the embodiment shown in FIG. 5, the markers are distinguishable from each other both with respect to their length dimension (in the direction x) as well as their width dimension (in the direction y). In other embodiments the markers are distinguishable from each other by their dimension in any of these directions. In still further embodiments, markers in a same sequence of markers have mutually different heights and/or mutually different widths.

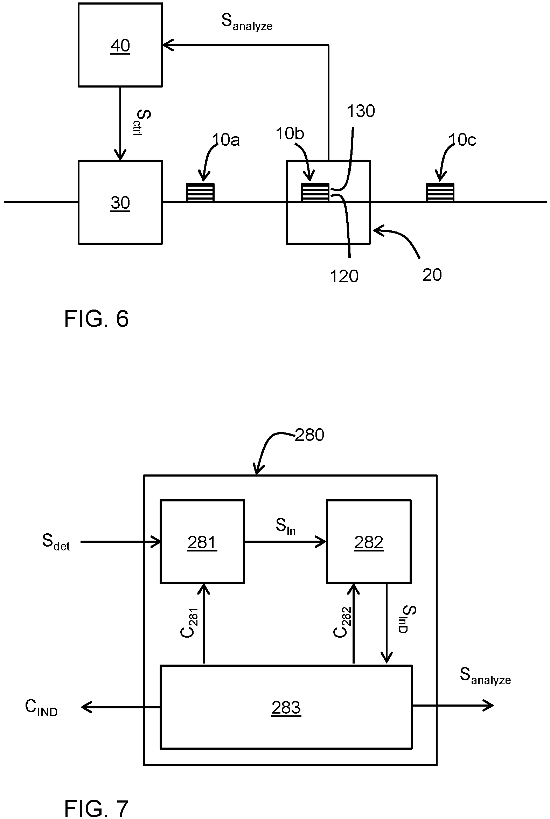

FIG. 6 shows a system comprising a layered product 10b and a scanning probe microscopy device 20. The system further comprises a production unit 30 that provides the layered product 10b with the at least a lower product layer 120 and the at least a higher product layer 130. The system also comprises a feedback control unit 40 that controls the production unit 30. In response to an analysis signal $S_{analysis}$ of the signal analyzer 280 (See FIG. 7) the feedback control unit 40 controls the production unit 30 with a control signal Sctrl so that the production unit 30 minimizes an alignment error with which it provides the at least a higher product layer 130 with respect to the at least a lower product layer 120.

FIG. 7 schematically shows a signal analyzer 280 that may be part of the scanning probe microscopy device 20. The signal analyzer 280 comprises a filter unit 281 a decoding unit 282, as well as an analysis control unit 283 that controls the filter unit 281 the decoding unit 282. In operation the analysis control unit 283 can instruct the filter unit 281 with a control signal $C_{281}$ to specifically filter a frequency band within the detection signal $S_{det}$

that is most relevant for a particular layer within the layered product. The selected frequency band for a layer that is arranged lower in the product may for example have a lower central frequency that a frequency band selected for a layer that is arranged higher in the product. The analysis control unit 283 can further instruct the decoding unit 282 with a control signal $C_{282}$ to apply a decoding operation specific to a particular layer of the layered product. The decoding unit 282 may for example apply a decoding of an error correction code. The analysis control unit 283 may be configured to successively perform the procedure for all product layers of the layered product, but may alternatively select to specific layers to determine their relative alignment. The analysis control unit 283 may further issue a control signal CIND to the indentation controller 260 so as to achieve that scanning of a lower product layer is performed with an indentation of the p robe tip into the product surface that is larger than that when performing scanning for the higher product layer. The signal analyzer 280 may further achieve that monitoring is performed multiple times for one, more or all product layers and compute an average value for the output signal values obtained therewith. For example, if the decoding unit 282 indicates a too high number of errors for a particular product layer, the analysis control unit 283 may preform control actions as a result of which monitoring is repeated for that layer.

In some embodiments the at least a first acoustic signal is applied to induce a compressional stress field in the layered product. In other embodiments, the at least a first acoustic signal is applied to induce a shear stress field in the layered product. In still further embodiments the at least a first acoustic signal is applied to induce a compressional stress field in the layered product and at least a second acoustic signal is applied to induce a shear stress field in the layered product. Since the compressional and shear stress fields are sensitive at different depths, combined compressional and shear detection can be used therein to increase the accuracy of the alignment/overlay. Compressional and shear detection can be performed simultaneously.

The present invention has been described in terms of some specific embodiments thereof. The embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

**Claims**

1. A layered product (10) with at least a lower product layer (120) comprising a first marker configuration(122) with at least a first marker (122a, 122b) and at least a higher product layer (130) that overlays the lower product layer, the at least a higher product layer comprising a second marker configuration (132) with at least a second marker (132a, 132b, 132c),
   **characterized in that** the first marker configuration (122) and the second marker configuration (132) have mutually different physical properties.

2. The layered product (10) according to claim 1, **characterized in that** the first marker configuration (122) and the second marker configuration (132) have mutually different physical properties **in that** a lateral dimension of the at least a first marker (122a) in the first marker configuration (122) is larger than that of the at least a second marker (132a) in the second marker configuration (132).

3. The layered product (10) according to claim 1, **characterized in that** the first marker configuration (122) and the second marker configuration (132) have mutually different physical properties **in that** the at least a first marker (122a) in the first marker configuration (122) has a depth profile (123) different from the depth profile (133) of the at least a second marker (132a) in the second marker configuration (132).

4. The layered product (10) according to claim 1, **characterized in that** the first marker configuration (122) and the second marker configuration (132) have mutually different physical properties **in that** at least one marker (122b, 132b) in one of the first marker configuration (122) and the second marker configuration (132) is of a material having a stiffness different from that of at least one other marker (122a, 132a, 132c) of the first marker configuration (122) and the second marker configuration (132).

5. The layered product (10) according to one of the previous claims, **characterized in that** the at least a first marker (122a) in the first marker configuration (122) is one of a plurality (122a, 122b) of first markers and **in that** the at least a second marker (132a) in the second marker configuration (132) is one of a plurality (132a, 132b, 132c) of second markers.

6. The layered product (10) according to claim 5, wherein the first marker configuration (122) and the second marker configuration (132) have mutually different physical properties in that a first pattern with which the plurality (132a, 132b, 132c) of second markers is arranged in the second marker configuration (132) differs from a second pattern with which the plurality (122a, 122b, 122c) of first markers is arranged in the first marker configuration (122).

7. The layered product (10) according to claim 6, wherein the first pattern differs from the second pattern by having mutually different values for one or more of a spatial frequency, a duty cycle and a phase with which the plurality of markers is arranged therein.

8. The layered product (10) according to claim 1, **characterized in that** the first marker configuration (122) and the second marker configuration (132) have mutually different physical properties **in that** at least one layer (120) comprises a marker configuration (122) with an encoded pattern of markers (122a, 122b,...,122n) that is specific for said at least one layer (120).

9. The layered product (10) according to claim 8, **characterized in that** the encoded pattern of markers (122aa,..,122ah, 122ba,..,122bf, 122ca,...,122ch, 122da,...,122dh) is provided as a two-dimensional pattern in the at least one layer (120).

10. A method of determining an alignment of the at least a lower product layer (120) and the at least a higher product layer (130) in the layered product (10) according to one of the previous claims, using a scanning probe microscopy device (20), wherein the scanning probe microscopy device comprises at least one scan head (210), the scan head including a probe (211), the probe comprising a flexible carrier (212) and a probe tip (213) arranged on the flexible carrier, wherein the method comprises:

moving the probe tip (213) and the layered product (10) relative to each other in one or more directions parallel to the surface (101) of the layered product for scanning said surface with the probe tip; and
monitoring motion of the probe tip relative to the scan head with a tip state detector during said scanning for obtaining a sense signal;
wherein the method further comprises:
during said scanning, applying at least a first acoustic input signal comprising a signal component at a first frequency to at least one of the probe or the layered product;
analyzing the sense signal for determining an alignment and/or overlay error of the at least a first marker configuration (122) in the lower product layer (120) and the at least a second marker configuration (132) in the higher product layer (130).

11. The method according to claim 10, wherein said scanning is performed for the lower product layer (120) with an indentation of the probe tip (213) into the product surface that is larger than that when performing the scanning of the higher product layer (130), wherein according to a first option the larger indentation of the probe tip (213) is achieved by a larger static force exerted on the probe tip, and wherein according to a second option the larger indentation of the probe tip (213) is achieved by using a modulated actuation with a higher carrier frequency.

12. The method according to claim 10 or 11, wherein said monitoring is performed multiple times and wherein an average value is computed for the sense signal values obtained therewith.

13. The method according to one of the claims 10-12, further comprising provide a shear acoustic wave in the layered product, the sense signal ($S_{sense}$) at least including a sense signal component indicative of torsional deflection of the probe tip, detecting said sense signal component and analyzing said detected sense signal component for determining an alignment and/or overlay error of the at least a first marker configuration (122) in the lower layer (120) and the at least a second marker configuration (132) in the higher layer (130).

14. A system comprising a layered product (10b) according to one of the claims 1-9 and a scanning probe microscopy device (20) to determine an alignment of the at least a lower product layer (120) and the at least a higher product layer (130) in said layered product (10b), wherein the scanning probe microscopy device (20) comprises at least one scan head (210), a scan unit (220), an acoustic signal generator (214), a tip state detector (240), a signal detector (250) and a signal analyzer (280), wherein the scan head (210) includes a probe (211), the probe comprising a flexible carrier (212) and a probe tip (213) arranged on the flexible carrier, the scanning probe microscopy device (20) being configured to assume an operational mode wherein:

- the scan unit (220) is configured to move the probe tip (213) and the layered product (10) relative to each other in one or more directions parallel to a surface (101) of the layered product for scanning said surface with the probe tip;
- the acoustic signal generator (214) is configured to apply at least a first acoustic input signal comprising a signal component at a first frequency to at least one of the probe or the layered product during operation of the scan unit,
- the tip state detector (240) is configured to monitor motion of the probe tip relative to the scan head for obtaining a sense signal;
- the signal detector (250) is configured to detect a sub-surface detection signal ($S_{det}$) based on the sense signal ($S_{sense}$); and
- the signal analyzer (280) is configured to analyze the sub-surface detection signal ($S_{det}$) for mapping the at least a first marker configuration (122) in the lower layer (120) and the at least a second marker configuration (132) in the higher layer (130).

15. The system according to claim 14, further comprising a shear wave actuator, configured to provide a shear acoustic wave in the substrate; and wherein the sense signal ($S_{sense}$) at least includes a sense signal component indicative of torsional deflection of the probe tip, the signal detector (250) being configured to detect said sense signal component and the signal analyzer (280) being configured to further analyze said detected sense signal component for mapping the at least a first marker configuration (122) in the lower layer (120) and the at least a second marker configuration (132) in the higher layer (130).

16. The system according to claim 14 or 15, further comprising at least one production unit (30) to provide the layered product (10) with said at least a lower product layer (120) and said at least a higher product layer (130), and a feedback control unit (40) that controls said at least one production unit and that is responsive to an analysis signal of the signal analyzer (280) to minimize an alignment error with which said at least one production unit provides the at least a higher product layer (130) with respect to said at least a lower product layer (120).

FIG. 1

FIG. 1A

FIG. 1B

$S_{dr}$

210

212

214

211

213

(a)

off structure
on structure

Amplitude

122a

122a

(b)

1

Amplitude contrast

0

-1

frequency ($f_m$)

FIG. 1C

FIG. 2

FIG. 3

FIG. 4

FIG. 5

FIG. 6

FIG. 7

Europäisches
Patentamt

European
Patent Office

Office européen
des brevets

# EUROPEAN SEARCH REPORT

Application Number

EP 20 17 1158

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 349 018 A1 (TNO [NL]) 18 July 2018 (2018-07-18) | 1-7,10, 12,14,16 | INV. G03F7/20 |
| Y | * paragraphs [0009], [0025] - [0031], | 8,9 | G03F9/00 |
| A | [0033]; claims 1, 11-14; figures 1,8,9 * ----- | 11 | G01N29/06 G01Q60/32 |
| X | TAMER M S ET AL: "Image-based overlay measurement using subsurface ultrasonic resonance force microscopy", PROCEEDINGS OF SPIE; [PROCEEDINGS OF SPIE ISSN 0277-786X VOLUME 10524], SPIE, US, vol. 10585, 13 March 2018 (2018-03-13), pages 1058500-1058500, XP060101423, DOI: 10.1117/12.2302959 ISBN: 978-1-5106-1533-5 | 1,10,14 | |
| Y | * the whole document * | 8,9 | |
| A |  | 11 | |
| X | EP 3 349 016 A1 (TNO [NL]) 18 July 2018 (2018-07-18) | 1,10, 13-15 | |
| Y | * abstract * | 8,9 | |
| A | * paragraphs [0008], [0026], [0028], [0021] - [0034]; claim 1; figures 1-3 * ----- | 11 | TECHNICAL FIELDS SEARCHED (IPC) |
| X | US 2006/103033 A1 (VAN HAREN RICHARD JOHANNES F [NL] ET AL) 18 May 2006 (2006-05-18) * paragraph [0056]; figure 2 * ----- | 1,2 | G03F G01N G01Q |
| Y | EP 3 599 470 A1 (TNO [NL]) 29 January 2020 (2020-01-29) * paragraphs [0022] - [0024]; figure 4 * ----- | 8,9 | |

The present search report has been drawn up for all claims

| Place of search | Date of completion of the search | Examiner |
|---|---|---|
| Munich | 15 October 2020 | Weckesser, Jens |

EPO FORM 1503 03.82 (P04C01)

## ANNEX TO THE EUROPEAN SEARCH REPORT
## ON EUROPEAN PATENT APPLICATION NO.

EP 20 17 1158

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2020

| Patent document cited in search report | | | Publication date | Patent family member(s) | | | Publication date |
|---|---|---|---|---|---|---|---|
| EP 3349018 | A1 | | 18-07-2018 | EP | 3349018 | A1 | 18-07-2018 |
| | | | | EP | 3568703 | A1 | 20-11-2019 |
| | | | | KR | 20190107687 | A | 20-09-2019 |
| | | | | TW | 201831906 | A | 01-09-2018 |
| | | | | US | 2019369139 | A1 | 05-12-2019 |
| | | | | WO | 2018132007 | A1 | 19-07-2018 |
| EP 3349016 | A1 | | 18-07-2018 | EP | 3349016 | A1 | 18-07-2018 |
| | | | | EP | 3568870 | A1 | 20-11-2019 |
| | | | | KR | 20190102252 | A | 03-09-2019 |
| | | | | TW | 201831894 | A | 01-09-2018 |
| | | | | US | 2019378769 | A1 | 12-12-2019 |
| | | | | WO | 2018132004 | A1 | 19-07-2018 |
| US 2006103033 | A1 | | 18-05-2006 | JP | 4583292 | B2 | 17-11-2010 |
| | | | | JP | 2006140500 | A | 01-06-2006 |
| | | | | US | 2006103033 | A1 | 18-05-2006 |
| | | | | US | 2010068830 | A1 | 18-03-2010 |
| EP 3599470 | A1 | | 29-01-2020 | EP | 3599470 | A1 | 29-01-2020 |
| | | | | WO | 2020022893 | A1 | 30-01-2020 |

EPO FORM P0459

For more details about this annex : see Official Journal of the European Patent Office, No. 12/82